# EUROPÄISCHE PATENTSCHRIFT

(11) **EP 1 212 799 B1**
(45) Veröffentlichungstag und Bekanntmachung des Hinweises auf die Patenterteilung: **20.07.2005**
(21) Anmeldenummer: 00975757.6
(22) Anmeldetag: 14.09.2000
(51) Int. Cl.: H01L 41/04, F02D 41/20

(54) **VORRICHTUNG ZUM ANSTEUERN WENIGSTENS EINES KAPAZITIVEN STELLGLIEDES**
DEVICE FOR CONTROLLING AT LEAST ONE CAPACITIVE ACTUATOR
DISPOSITIF POUR COMMANDER AU MOINS UN ORGANE DE REGLAGE CAPACITIF

(30) Priorität: 17.09.1999 DE 19944733
(43) Veröffentlichungstag der Anmeldung: 12.06.2002
(73) Patentinhaber: SIEMENS AKTIENGESELLSCHAFT, 80333 München (DE)
(72) Erfinder: SCHROD, Walter, 93057 Regensburg (DE)
(86) Internationale Anmeldenummer: PCT/DE2000/003206
(87) Internationale Veröffentlichungsnummer: WO 2001/022502

(56) Entgegenhaltungen:
- DE-A- 19 644 521
- DE-A- 19 900 474
- US-A- 5 543 679
- PATENT ABSTRACTS OF JAPAN vol. 017, no. 126 (M-1381), 17. März 1993 (1993-03-17) & JP 04 308338 A (NIPPONDENSO CO LTD), 30. Oktober 1992 (1992-10-30)
- PATENT ABSTRACTS OF JAPAN vol. 012, no. 454 (M-769), 29. November 1988 (1988-11-29) -& JP 63 183250 A (NIPPON DENSO CO LTD;OTHERS: 01), 28. Juli 1988 (1988-07-28)
- PATENT ABSTRACTS OF JAPAN vol. 014, no. 447 (M-1029), 25. September 1990 (1990-09-25) -& JP 02 176121 A (TOYOTA MOTOR CORP), 9. Juli 1990 (1990-07-09)
- PATENT ABSTRACTS OF JAPAN vol. 011, no. 325 (E-551), 22. Oktober 1987 (1987-10-22) -& JP 62 114482 A (YOKOGAWA ELECTRIC CORP), 26. Mai 1987 (1987-05-26)
- PATENT ABSTRACTS OF JAPAN vol. 013, no. 518 (E-848), 20. November 1989 (1989-11-20) & JP 01 209965 A (TOYOTA MOTOR CORP), 23. August 1989 (1989-08-23)
- PATENT ABSTRACTS OF JAPAN vol. 018, no. 507 (E-1609), 22. September 1994 (1994-09-22) & JP 06 177449 A (TOYOTA MOTOR CORP), 24. Juni 1994 (1994-06-24)

## Beschreibung

Die Erfindung betrifft ein Verfahren zum Ansteuern wenigstens eines kapazitiven Stellgliedes, insbesondere eines Kraftstoffeinspritzventils einer Brennkraftmaschine, nach dem Oberbegriff des Anspruchs 1. Sie betrifft auch eine Vorrichtung zur Durchführung dieses Verfahrens.

Bei bekannten Verfahren zum Ansteuern kapazitiver Stellglieder erfolgt der Ladeprozeß als Umschwingvorgang der Ladung von einer Ladungsquelle über eine Umladespule zum Stellglied, wobei die Induktivität der Umladespule zusammen mit den Kapazitäten der Ladungsquelle und des Stellgliedes die Zeitkonstante für den Lade- und Entladevorgang (die Lade- und Entladezeit) bestimmt.

Aus US 5,130,598 ist eine Vorrichtung zum Ansteuern eines kapazitiven Stellgliedes bekannt, bei welcher ein Piezo-Stellglied von einer Energiequelle über einen Ladeschalter und eine Spule mit von dem durch das Stellglied fließenden Strom und der an ihm anliegenden Spannung abhängigen Spannungsimpulsen geladen und entladen wird. Die Energiequelle muß wenigstens eine der maximalen Stellgliedspannung entsprechende Spannung liefern können, was sie zusammen mit der aufwendigen Schaltung sehr kostenintensiv macht.

Aus Patent Abstracts of Japan vol.017, no. 126(M-1381), 17.März 1993 (1993-03-17)&JP04308338 A (Nippondenso Co Ltd), 30.Oktober 1993 (1992-10-30) ist eine Vorrichtung zum Laden eines kapazitiven Stellgliedes mittels eines Transformators bekannt, wobei der Ladestrom ungeregelt ansteigt und nach Erreichen eines vorgegebenen Werts durch Pulsweitenmodulation konstant gehalten wird und die Entladung ungeregelt erfolgt, da der Widerstand R1, über den ein Rückmeldesignal erfolgen könnte, nicht als Strommeßshunt ausgelegt ist.

In Patent Abstracts of Japan vol.012, no.454(M-769), 29.November 1988(1988-11-29)&JP63183250 A (Toyota Motor Corp) 28.Juli.1988 (1988-07-28) ist eine Steuerschaltung für einen Piezoaktuator beschrieben. Weder primärseitig noch sekundärseitig ist eine Strommessung vorhanden, die eine Stromregelung ermöglichen könnte.

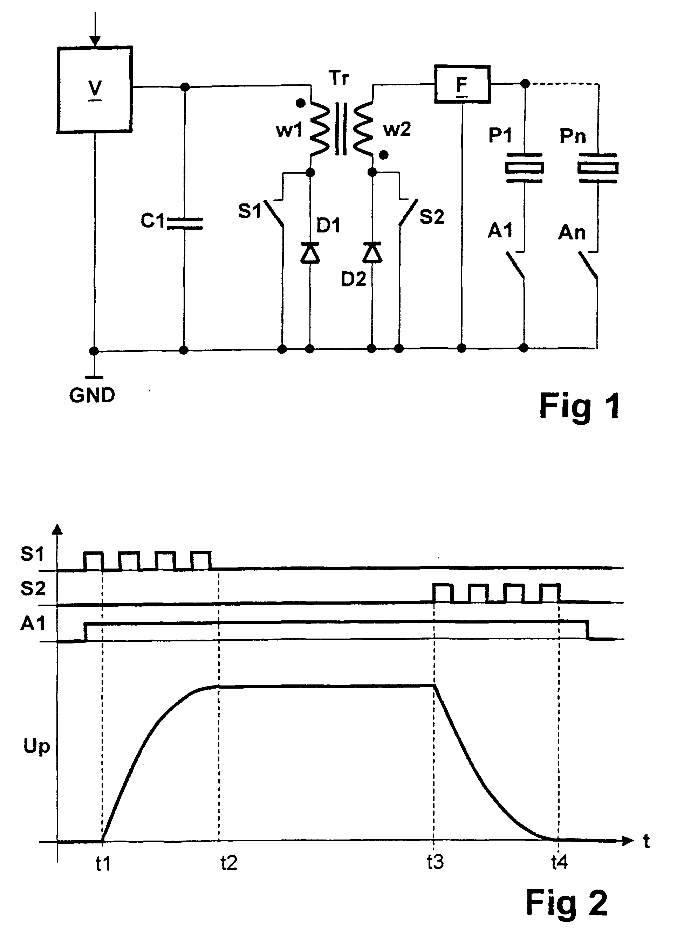

Die US 5,543,679 beschreibt eine Ansteuerschaltung für in Kraftstoffeinspritzventilen verwendete Piezo-Aktoren nach dem Resonanzverfahren, wobei die Aufladung des Stellgliedes in einem einzigen Umschwingvorgang der Ladung über einen Transformator erfolgt. Die Entladung erfolgt entweder durch Vernichtung der Energie über eine weitere geschaltete Spule ohne Energierückgewinnung (Figuren 1, 7 und 8) oder mit Energierückgewinnung mit zusätzlichen Bauelementen (Figur 10: Transformator 91, Kondensator 93, Dioden 92, 94 und zusätzliche Spule 95).

In US 5,479,062 ist eine Ansteuerschaltung für Piezo-Aktoren von Matrix-Druckern beschrieben. Die Ansteuerung erfolgt über einen Transformator nach dem Resonanzverfahren. Da die Nadeln eines solchen Matrixdruckers immer möglichst schnell und mit gleicher Kraft, aber nicht nur seriell, sondern auch parallel, d.h., gleichzeitig betätigt werden, ist für alle Piezo-Aktoren ein einziger Spannungsdetektor und nur eine Regelschaltung vorhanden, die in Abständen die Piezospannung jedes einzelnen Aktors 3 kontrollieren und abhängig davon den Ladestrom einregeln; für jeden Piezo-Aktor ist aber wegen der parallelen Ansteuerung eine eigene Ansteuerschaltung mit Transformator sowie Lade- und Entladeschalter erforderlich. Der Verlauf der Ladespannung ist nicht veränderbar, es erfolgt nur ein Umschwingvorgang mit einem Ladestrom, der eine bestimmte Stellgliedspannung bewirkt. Es findet auch keine Energierückgewinnung statt, denn die Energie wird im Sekundärkreis vernichtet.

Es ist Aufgabe der Erfindung, ein Verfahren zum Ansteuern wenigstens eines kapazitiven Stellgliedes anzugeben, bei dem das Aufladen und Entladen wenigstens eines kapazitiven Stellgliedes mit weitgehend frei wählbaren Größen für Dauer und Verlauf des Auflade-/Entladevorgangs vorgenommen werden kann. Es ist auch Aufgabe der Erfindung, eine Vorrichtung zur Durchführung dieses Verfahrens zu schaffen.

Diese Aufgabe wird erfindungsgemäß durch die im Anspruch 1 bzw. Anspruch 5 genannten Merkmale gelöst.

Ein Ausführungsbeispiel nach der Erfindung ist im folgenden unter Bezugnahme auf die schematische Zeichnung näher erläutert. Es zeigen:
- Figur 1: ein Prinzipschaltbild einer Vorrichtung zur Durchführung des erfindungsgemäßen Verfahrens,
- Figur 2: ein Diagramm der Ansteuersignale und der sich daraus ergebenden Stellgliedspannung, und
- Figur 3: ein Schaltbild einer erweiterten Vorrichtung.

Zum besseren Verständnis der Erfindung wird zunächst die Vorrichtung beschrieben, mittels welcher das erfindungsgemäße Verfahren durchgeführt werden soll.

Die in Figur 1 dargestellte Prinzipschaltung einer Vorrichtung zum Ansteuern von kapazitiven Stellgliedern P1 bis Pn, beispielsweise für Kraftstoffeinspritzventile einer Brennkraftmaschine, wird von einer Energiequelle versorgt, welche in diesem Ausführungsbeispiel aus einem von einer Bordnetzspannung gespeisten DC/DC-Wandler V mit einstellbarer Ausgangsspannung und einem auf dessen jeweilige Ausgangsspannung aufgeladenen Ladekondensator C1 besteht.

Parallel zum Ladekondensator C1 liegt eine Reihenschaltung der Primärspule w1 eines Transformators Tr und eines Ladeschalters S1. Zwischen Bezugspotential GND und dem mit dem Ladeschalter S1 verbundenen Anschluß der Primärspule w1 ist eine vom Bezugspotential GND zur Primärspule w1 hin stromleitende Diode D1 angeordnet.

Der eine Anschluß der Sekundärspule w2 des Transformators Tr ist über einen Entladeschalter S2 mit dem Bezugspotential GND verbunden, wobei zwischen Bezugspotential GND und dem mit dem Entladeschalter S2 verbundenen Anschluß der Sekundärspule w2 eine vom Bezugspotential GND zur Sekundärspule w2 hin stromleitende weitere Diode D2 angeordnet ist.

Zwischen dem anderen Anschluß der Sekundärspule w2 und Bezugspotential GND ist das anzusteuernde kapazitive Stellglied angeordnet. Sind mehrere Stellglieder vorgesehen, wie in Figur 1 dargestellt, so sind diese parallel zueinander angeordnet, wobei mit jedem Stellglied P1 bis Pn ein mit Bezugspotential GND verbundener Auswahlschalter A1 bis An in Reihe geschaltet ist.

Zwischen der Sekundärspule w2 und dem Stellglied bzw. den Stellgliedern ist in weiterer Ausgestaltung der Erfindung ein Filter F, beispielsweise ein Tiefpaßfilter, angeordnet.

Die Steuersignale des Ladeschalters S1, des Entladeschalters S2, der Auswahlschalter A1 bis An und das Steuersignal zum Einstellen der Ausgangsspannug des DC/DC-Wandlers V werden von einer nicht dargesatellten Steuerschaltung ausgegeben, die Teil eines Motorsteuergeräts sein kann.

Diese erfindungsgemäße Vorrichtung hat den Vorteil, daß die Energiequelle eine wesentlich geringere Spannung als die am Stellglied benötigte Spannung erzeugen muß, und daß die Lade- und Entladedauer, die Spannung Up am Stellglied, um einen bestimmten Hub zu erzeugen, sowie der Lade- und Entladeverlauf der Stellgliedspannung Up beliebig festgelegt werden können.

Die beschriebene Vorrichtung zum Ansteuern eines Stellgliedes, hier des Stellgliedes P1 (die Ansteuerung weiterer Stellglieder erfolgt in gleicher Weise), in dieser einfachen Form arbeitet nach dem erfindungsgemäßen Verfahren, das nachstehend beschrieben wird, folgendermaßen:
In einem Anfangszustand sind alle kapazitiven Stellglieder P1 bis Pn entladen, sind alle Schalter S1, S2 und A1 bis An nichtleitend, und ist der Ladekondensator C1 auf eine vorgegebene Ausgangsspannung des DC/DC-Wandlers V aufgeladen.

Die Ansteuersignale für den Ladeschalter S1, den Entladeschalter S2 und den Auswahlschalter A1 sowie die daraus resultierende Stellgliedspannung Up sind in Figur 2 dargestellt.

Wenn das Stellglied P1 geladen werden soll, wird der Auswahlschalter A1 im Zeitpunkt des Ladebeginns leitend gesteuert. Er bleibt bis über den Zeitpunkt t4, in welchem das Stellglied P1 wieder entladen ist, leitend.

Zum Aufladen des Stellgliedes wird der Ladeschalter S1 mit vorgegebener Frequenz und vorgegebenem Tastverhältnis im Pulsbetrieb mit einer vorgegebenen Zahl von Pulsweitenmodulierten Signalen bei der vorgegebenen Ladespannung angesteuert. Während des leitenden Zustandes des Ladeschalters S1 steigt der Strom durch die Primärspule w1 an und wird im Zeitpunkt t1 durch Öffnen (nichtleitendsteuern) des Ladeschalters S1 abgebrochen.

In dieser nichtleitenden Phase der Primärseite fließt über die Sekundärwicklung w2 bei einem dem Windungsverhältnis w2/w1 entsprechenden Strom eine impulsförmige Spannung, die in dem Filter F geglättet wird, und lädt das Stellglied P1 mit jedem Strompuls weiter auf, bis im Zeitpunkt t2 nach der vorgegenenen Zahl von Pulsen eine vorgegebene Stellgliedspannung Up in etwa erreicht ist. Der Sekundärkreis wird beim Laden des Stellgliedes über den Auswahlschalter A1 und die Diode D2 geschlossen.

Die Ladezeit t2-t1 , die beispielsweise zwischen 100µs und 200µs betragen kann, kann je nach Tastverhältnis variiert werden, wobei die Zahl der Pulse der gewünschten Stellgliedspannung Up anzupassen ist.

Die Entladung des Stellgliedes ab dem Zeitpunkt t3 erfolgt ebenfalls mit Pulsweiten-modulierten Signalen dadurch, daß der Entladeschalter S2 pulsförmig leitend und nichtleitend gesteuert wird, wodurch die Stellgliedspannung Up sinkt und im Zeitpunkt t4 zu null wird. Die Entladezeit t4-t3 kann ebenfalls je nach Tastverhältnis variiert werden. Dabei fließt der Strom vom Stellglied über das Filter F, die Sekundärspule w2, den Entladeschalter S2 und den Auswahlschalter A1 zurück zum Stellglied.

Bei jedem Öffnen des Entladeschalters S2 wird ein Teil der Entladeenergie auf die Primärseite des Transformators Tr übertragen und in den Ladekondensator C1 rückgespeichert. Der Primärstromkreis schließt sich über die Diode D1.

Dieser gesteuerte Betrieb ist unbefriedigend, weil infolge von Temperaturänderungen und Toleranzen der Schaltung, insbesondere des Transformators, die Ladespannung bzw. Ladeenergie oder Ladung, und damit der Hub des Stellgliedes nur näherungsweise bestimmt werden kann.

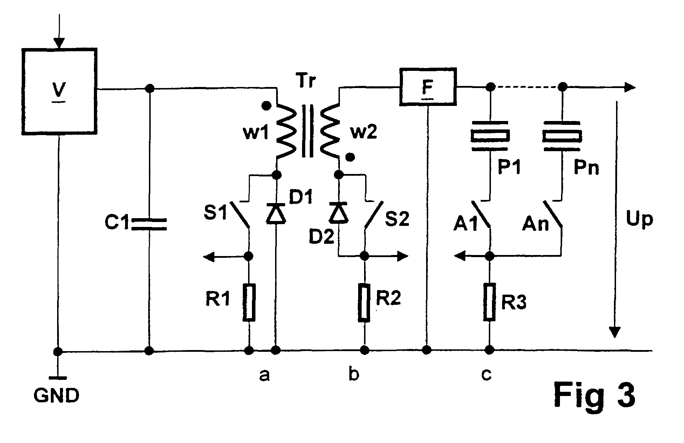

Aus diesem Grund sind in der erweiterten Schaltung nach Figur 3 eine erste und eine zweite Meßeinrichtung in Form zweier Strommeßwiderstände R1 und R2 jeweils zwischen Ladeschalter S1 bzw. Entladeschalter S2 und Bezugspotential GND eingefügt, so daß mittels der am Meßwiderstand R1 abfallenden Spannung der zu ihr proportionale primäre Ladestrom und mittels der am Meßwiderstand R2 abfallenden Spannung der zu ihr proportionale sekundäre Entladestrom in der nicht dargestellten Steuerschaltung gemessen und danach die Auf- oder Entladung des Stellgliedes eingeregelt werden kann.

Auch die Stellgliedspannung Up kann gemessen und mit vorgegebenen Schwellwerten verglichen werden. Die Stellgliedspannung Up läßt erkennen, wann ein Stellglied auf eine einer bestimmten Energie bzw. Ladung oder einem bestimmten Hub zugeordnete Spannung aufgeladen ist. Sie kann auch zum Nachladen eines Stellgliedes während einer längeren Haltephase (zwischen Laden und Entladen) benutzt werden, wenn sich das Stellglied über parasitäre Widerstände langsam selbst entlädt.

Die Dioden D1 und D2 können dabei, wie in Figur 2 als Lösung a angegeben, parallel zur Reihenschaltung aus Lade- bzw. Entladeschalter S1, S2 und Meßwiderstand R1 bzw. R2 angeordnet sein; sie können aber auch nur parallel zum Lade- bzw. Entladeschalter S1, S2 und in Reihe mit dem jeweiligen Meßwiderstand R1, R2, wie als Lösung b eingezeichnet, angeordnet sein. Damit ist es möglich, über den Meßwiderstand R1 den Ladestrom primärseitig zu messen und ggf. duurch Vergleich mit vorgegebenen Schwellwerten auf bestimmte Werte zu begrenzen; über den Meßwiderstand R2 kann der Entladestrom sekundärseitig gemessen werden.

Soll auch oder alternativ der Ladestrom sekundärseitig gemessen werden, so kann dazu eine dritte Meßeinrichtung, ein Meßwiderstand R3 verwendet werden, der zwischen dem Bezugspotential und einem gemeinsamen Verbindungspunkt aller Auswahlschalter A1 bis An angeordnet ist, wie in Figur 3 als Lösung c dargestellt ist.

Zur sekundärseitigen Messung des Ladestroms könnte auch die zweite Meßeinrichtung - Meßwiderstand R2 - herangezogen werden, an der aber in diesem Fall eine negative Spannung abfällt, wozu eine aufwendigere Meßschaltung erforderlich wäre.

Mit dieser Schaltung können nun abhängig von den genannten, gemessenen Größen mittels Konstantwerten oder durch Variation der Ladekondensatorspannung, der Frequenz und des Tastverhältnisses der Pulsweiten-modulierten Steuersignale (letzteres auch über die Vorgabe von Stromschwellwerten für den Vergleich mit dem mittels der Meßwiderstände R1 und R2 ermittelten Lade- oder Entladestrom und mittels der Abfolge - kontinuierliche Pulsfolge oder Auslassen einzelner Pulse - für den Lade- und Entladeschalter S1 und S2) alle möglichen Formen und Dauern der Lade- und Entladekurve der Stellgliedspannung Up für jedes einzelne Stellglied dargestellt werden. Jedes Stellglied kann mit einem jeweils vorgegebenen, konstanten Energie- oder Ladungsbetrag, mit einem an die temperaturabhängige Kapazität des jeweiligen Stellgliedes angepaßten Energie- oder Ladungsbetrag oder mit einem einen gewünschten Hub des jeweiligen Stellgliedes bewirkenden Energie- oder Ladungsbetrag angesteuert werden.

Außerdem können auf diese Weise Eigenheiten und Toleranzen der Schaltung, beispielsweise Kerneigenschaften des Transformators Tr, kompensiert werden.

## Patentansprüche

1. Verfahren zum Ansteuern wenigstens eines kapazitiven Stellgliedes (P1...Pn), insbesondere für wenigstens ein Kraftstoffeinspritzventil einer Brennkraftmaschine,
**dadurch gekennzeichnet,**
**daß** das Auf- und Entladen des wenigstens einen Stellgliedes (P1...Pn) mit einem pulsweitenmodulierten Lade- und Entladestrom mit vorgebbarem Verlauf von Frequenz oder Tastverhältnis mit kontinuierlicher oder durch Auslassen einzelner Pulse vorgegebener Pulsfolge erfolgt.

2. Verfahren nach Anspruch 1, **dadurch gekennzeichnet, daß** das Tastverhältnis über die Pulsdauer bestimmt wird, die solange dauert, bis der Lade- oder Entladestrom einen vorgebbaren Wert erreicht.

3. Verfahren nach Anspruch 1, **dadurch gekennzeichnet, daß** das Aufladen des wenigstens einen Stellgliedes (P1...Pn) aus einer Energiequelle (V) erfolgt, die als DC/DC-Wandler mit einstellbarer Ausgangsspannung ausgebildet ist, dem ein Ladekondensator (C1) parallelgeschaltet ist.

4. Verfahren nach Anspruch 1, **dadurch gekennzeichnet, daß** das Aufladen des Stellgliedes (P1...Pn) so lange dauert, bis eine einer bestimmten Ladung, einem bestimmten Energiebetrag oder einem bestimmten Hub zugeordnete Stellgiedspannung (Vp) erreicht ist.

5. Vorrichtung zur Durchführung des Verfahrens nach Anspruch 1, mittels einer Steuerschaltung und eines Transformators (Tr),
wobei der eine Anschluß der Primärspule (w1) des Transformators (Tr) mit dem einen Pol der Energiequelle (V), und der andere Anschluß mit einem Ladeschalter (S1) und mit einer zur Primärspule hin stromleitenden, ersten Diode (D1) verbunden ist, und
wobei der eine Anschluß der Sekundärspule (w2) des Transformators (Tr) mit dem wenigstens einen Stellglied (P1...Pn), und der andere Anschluß mit einem Entladeschalter (S2) und mit einer zur Sekundärspule hin stromleitenden, zweiten Diode (D2) verbunden ist,
**dadurch gekennzeichnet,**
**daß** zwischen dem Ladeschalter (S1) und dem anderen Pol (GND) der Energiequelle (V) eine erste Meßeinrichtung (R1) zum Messen des primärseitigen Ladestroms angeordnet ist,
**daß** zwischen dem Entladeschalter (S2) und dem anderen Pol (GND) der Energiequelle (V) eine zweite Meßeinrichtung (R2) zum Messen des sekundärseitigen Entladestroms angeordnet ist,
**daß** die erste Diode (D1) entweder parallel zum Ladeschalter (S1) oder parallel zur Reihenschaltung aus Ladeschalter (S1) und erster Meßeinrichtung (R1) geschaltet ist, und
**daß** die zweite Diode (D2) entweder parallel zum Entladeschalter (S2) oder parallel zur Reihenschaltung aus Entladeschalter (S2) und zweiter Meßeinrichtung (R2) geschaltet ist.

6. Vorrichtung nach Anspruch 5, **dadurch gekennzeichnet, daß** in Reihenschaltung mit dem einen Stellglied (P1) oder mit den parallelgeschalteten Reihenschaltungen aus je einem Stellglied (P1...Pn) und einem ihm zugeordneten Auswahlschalter (A1...An) eine dritte Meßeinrichtung (R3) zum Messen des sekundärseitigen Ladestroms angeordnet ist.

7. Vorrichtung nach Anspruch 5 oder 6, **dadurch gekennzeichnet, daß** eine vierte Meßeinrichtung zum Messen der Stellgliedspannung (Up) vorgesehen ist.

## Claims

1. Method for driving at least one capacitive actuator, in particular for at least one fuel injection valve of an internal combustion engine,
**characterized**
**in that** the at least one actuator (P1...Pn) is charged and discharged with a pulse-width-modulated charging and discharge current with a predeterminable profile of frequency or duty ratio with a pulse sequence that is continuous or predetermined by omission of individual pulses.

2. Method according to Claim 1, **characterized in that** the duty ratio is determined by way of the pulse duration, which lasts until the charging or discharge current reaches a predeterminable value.

3. Method according to Claim 1, **characterized in that** the at least one actuator (P1...Pn) is charged from a power source (V) which is designed as a DC/DC converter with an adjustable output voltage, with which a charging capacitor (C1) is connected in parallel.

4. Method according to Claim 1, **characterized in that** the charging of the actuator (P1...Pn) lasts until an actuator voltage (Vp) associated with a specific charge, a specific amount of energy or a specific change is reached.

5. Apparatus for carrying out the method according to Claim 1, by means of a control circuit and a transformer (Tr),
one connection of the primary coil (w1) of the transformer (Tr) being connected to one pole of the power source (V) and the other connection being connected to a charging switch (S1) and to a first diode (D1) which is forward-biased towards the primary coil, and
one connection of the secondary coil (w2) of the transformer (Tr) being connected to the at least one actuator (P1...Pn) and the other connection being connected to a discharge switch (S2) and to a second diode (D2) which is forward-biased towards the secondary coil,
**characterized**
**in that** a first measurement device (R1) for measuring the primary-side charging current is arranged between the charging switch (S1) and the other pole (GND) of the power source (V),
**in that** a second measurement device (R2) for measuring the secondary-side discharge current is arranged between the discharge switch (S2) and the other pole (GND) of the power source (V),
**in that** the first diode (D1) is connected either in parallel with the charging switch (S1) or in parallel with the series circuit comprising the charging switch (S1) and the first measurement device (R1), and
**in that** the second diode (D2) is connected either in parallel with the discharge switch (S2) or in parallel with the series circuit comprising the discharge switch (S2) and the second measurement device (R2).

6. Apparatus according to Claim 5, **characterized in that** a third measurement device (R3) for measuring the secondary-side charging current is arranged in a series circuit with the one actuator (P1) or with the parallel-connected series circuits comprising a respective actuator (P1...Pn) and a selection switch (A1...An) associated therewith.

7. Apparatus according to Claim 5 or 6, **characterized in that** a fourth measurement device for measuring the actuator voltage (Up) is provided.

## Revendications

1. Procédé pour commander au moins un actionneur capacitif (P1...Pn), en particulier pour au moins un injecteur de carburant d'un moteur à combustion interne,
**caractérisé en ce que**
la charge et la décharge de l'au moins un actionneur (P1...Pn) s'effectue avec un courant de charge et de décharge modulé en largeur des impulsions, avec un profil de fréquence pouvant être prédéterminé ou de taux d'impulsion pouvant être prédéterminé, avec une suite d'impulsions continue ou prédéterminée par l'abandon d'impulsions isolées.

2. Procédé selon la revendication 1, **caractérisé en ce que** le taux d'impulsion est déterminé au moyen de la durée des impulsions, qui dure jusqu'à ce que le courant de charge ou de décharge atteigne une valeur pouvant être prédéterminée.

3. Procédé selon la revendication 1, **caractérisé en ce que** la charge de l'au moins un actionneur (P1...Pn) s'effectue à partir d'une source d'énergie (V) qui est constituée par un convertisseur continu/continu ayant une tension de sortie réglable, en parallèle avec lequel un condensateur de charge (C1) est connecté.

4. Procédé selon la revendication 1, **caractérisé en ce que** la charge de l'actionneur (P1...Pn) dure jusqu'à ce qu'on ait atteint une tension d'actionneur (Vp) qui correspond à un état de charge déterminé, à une valeur d'énergie déterminée ou à une course déterminée.

5. Dispositif pour la mise en oeuvre du procédé selon la revendication 1, au moyen d'un circuit de commande et d'un transformateur (Tr),
dans lequel l'une des connexions de l'enroulement primaire (w1) du transformateur (Tr) est reliée à l'un des pôles de la source d'énergie (V) et l'autre connexion est reliée à un interrupteur de charge (S1) et à une première diode (D1) qui laisse passer le courant vers l'enroulement primaire, et
dans lequel l'une des connexions de l'enroulement secondaire (w2) du transformateur (Tr) est reliée à l'au moins un actionneur (P1...Pn) et l'autre connexion est reliée à un interrupteur de décharge (S2) et à une seconde diode (D2) qui laisse passer le courant vers l'enroulement secondaire,
**caractérisé**
**en ce que**, entre l'interrupteur de charge (S1) et l'autre pôle (GND) de la source d'énergie (V), est disposé un premier dispositif de mesure (R1) destiné à mesurer le courant de charge côté primaire,
**en ce que**, entre l'interrupteur de décharge (S2) et l'autre pôle (GND) de la source d'énergie (V) est disposé un second dispositif de mesure (R2) destiné à mesurer le courant de décharge côté secondaire,
**en ce que** la première diode (D1) est connectée, soit en parallèle avec l'interrupteur de charge (S1), soit en parallèle avec le circuit série composé de l'interrupteur de charge (S1) et du premier dispositif de mesure (R1), et
**en ce que** la seconde diode (D2) est connectée, soit en parallèle avec l'interrupteur de décharge (S2), soit en parallèle avec le circuit série composé de l'interrupteur de décharge (S2) et du second dispositif de mesure (R2).

6. Dispositif selon la revendication 5, **caractérisé en ce que**, en série avec l'un des actionneurs (P1) ou avec les circuits série connectés en parallèle composés chacun d'un actionneur (P1...Pn) et d'un interrupteur de sélection (A1...An) qui lui correspond, est disposé un troisième dispositif de mesure (R3) destiné à mesurer le courant de charge côté secondaire.

7. Dispositif selon la revendication 5 ou 6, **caractérisé en ce qu'**il est prévu un quatrième dispositif de mesure destiné à mesurer la tension d'actionneur (Up).
